# EUROPÄISCHE PATENTANMELDUNG

(11) **EP 2 369 619 A2**
(43) Veröffentlichungstag der Anmeldung: **28.09.2011**
(21) Anmeldenummer: 11151100.2
(22) Anmeldetag: 17.01.2011
(51) Int. Cl.: H01L 23/00

(54) **Schaltungsanordnung mit einer elektrischen Komponente und einer Verbundfolie**

(30) Priorität: 24.03.2010 DE 102010012457
(71) Anmelder: Semikron Elektronik GmbH & Co. KG Patentabteilung, 90431 Nürnberg (DE)
(72) Erfinder: Braml, Heiko, 91346 Wiesenttal (DE); Windischmann, Jürgen, 96178 Pommersfelden (DE); Sagebaum geb. Herrmann, Ulrich, 90537 Feucht (DE)

(57) **Zusammenfassung**

Es wird eine Schaltungsanordnung mit einer elektrischen Komponente (10) und mit einer Verbundfolie (12) beschrieben. Die elektrische Komponente (10) weist eine schaltstrukturierte Metalllage (14) auf. Die Verbundfolie (12) weist eine schaltstrukturierte Logikmetallschicht (22) und eine schaltstrukturierte Leistungsmetallschicht (20) und zwischen diesen Schichten (20 und 22) eine elektrisch isolierende Folie (18) auf. Die schaltstrukturierte Leistungsmetallschicht (20) und die elektrisch isolierende Folie (18) sind deckungsgleich mit einer Ausnehmung (24) ausgebildet. Die Logikmetallschicht (22) ist durch die Ausnehmung (24) hindurch, an der schaltstrukturierten Metalllage (14) der elektrischen Komponente (10) anliegend, eingedrückt. Die Logikmetallschicht (22) ist mit der schaltstrukturierten Metalllage (14) der elektrischen Komponente (10) elektrisch leitend verbunden.

## Beschreibung

Die Erfindung betrifft eine Schaltungsanordnung mit einer elektrischen Komponente, die eine schaltstrukturierte Metalllage aufweist, und mit einer Verbundfolie, die eine schaltstrukturierte Logikmetallschicht und eine schaltstrukturierte Leistungsmetallschicht und zwischen diesen Schichten eine elektrisch isolierende Folie aufweist.

Bei der elektrischen Komponente kann es sich bspw. um ein Substrat eines Leistungshalbleitermoduls oder um ein Leistungshalbleiterbauelement oder dergleichen handeln.

Eine derartige Schaltungsanordnung ist beispielsweise aus der DE 103 55 925 B4 der Anmelderin oder aus der DE 10 2005 053 398 B4 der Anmelderin bekannt. Gemäß der DE 103 55 925 B4 weist die Verbundfolie Kontaktnoppen und Durchkontaktierungen auf. Die Verbundfolie ist mit Leistungshalbleiterbauelementen und Distanzelementen, die auf dem Substrat vorgesehen sind, durch Ultraschallschweißen dauerhaft verbunden. Gemäß der genannten DE 10 2005 053 398 B4 ist die Verbundfolie mit Kontaktnoppen zur Kontaktierung mindestens eines Leistungshalbleiterbauelementes ausgebildet und sind zwischen der schaltstrukturierten Logikmetallschicht und der schaltstrukturierten Leistungsmetallschicht Durchkontaktierungen vorgesehen. Die elektrisch isolierende Folie der Verbundfolie ist im Bereich der jeweiligen Durchkontaktierung an einem von der Logikmetallschicht freien Bereich mit einer Aussparung ausgebildet. Ein Dünndraht erstreckt sich durch den von der Logikmetallschicht freien Bereich und durch die Aussparungen der Isolierfolie hindurch und ist mit der schaltstrukturierten Logikmetallschicht und mit der Leistungsmetallschicht durch Bondstellen kontaktiert.

Ein Halbleitermodul mit gebondeten Dünndrähten zur Verschaltung von Leistungshalbleiterbauelementen, die an einem Substrat vorgesehen sind, ist beispielsweise auch aus der US 5,422,515 bekannt.

Bondverbindungen stellen jedoch oftmals Probleme dar. Desgleichen kann die Betriebszuverlässigkeit bekannter Schaltungsanordnungen noch Wünsche offen lassen. Außerdem sind oft aufwändige und in ihrer Herstellung teuere Metallisierungsverfahren notwendig, um gewünschte Durchkontaktierungen zu schaffen.

In Kenntnis dieser Gegebenheiten liegt der Erfindung die Aufgabe zugrunde, eine Schaltungsanordnung der eingangs genannten Art zu schaffen, bei welcher Durchkontaktierungen einfach herstellbar - und zweckmäßigerweise direkt während eines Chip-Verbindungsprozesses realisierbar sind.

Diese Aufgabe wird erfindungsgemäß durch die Merkmale des Anspruches 1, d.h. dadurch gelöst, dass die schaltstrukturierte Leistungsmetallschicht und die Isolierfolie mit einer Ausnehmung ausgebildet sind, dass die Logikmetallschicht durch die Ausnehmung hindurch, an der schaltstrukturierten Metalllage der elektrischen Komponente anliegend, eingedrückt ist, und dass die Logikmetallschicht der Verbundfolie mit der Metalllage der elektrischen Komponente elektrisch leitend verbunden ist. Bei der elektrischen Komponente kann es sich - wie bereits erwähnt worden ist - um ein Substrat eines elektrischen Bauteils wie bspw. eines Leistungshalbleitermoduls oder um ein Leistungshalbleiterbauelement handeln. Bei der elektrisch leitenden Verbindung kann es sich um eine stoffschlüssige Verbindung oder um eine kraftschlüssige Verbindung handeln. Die stoffschlüssige Verbindung kann bspw. durch Drucksintern realisiert sein.

Die erfindungsgemäß Schaltungsanordnung weist den Vorteil auf, dass zur Außenseite der Verbundfolie, d.h. zur schaltstrukturierten Logikmetallschicht hin, keine Öffnungen vorhanden sind, durch welche Feuchtigkeit von außen in die Schaltungsanordnung eindringen könnte, so dass sich direkt und unmittelbar eine dichte Schaltungsanordnung, bspw. ein dichtes Leistungshalbleitermodul, ergibt.

Die Durchkontaktierung mit einem Isoliermaterial abzudecken, wie in der oben zitierten DE 10 2005 053 398 B4 offenbart worden ist, ist erfindungsgemäß in vorteilhafter Weise also entbehrlich. Weitere Vorteile der erfindungsgemäß Schaltungsanordnung bestehen in ihrer preisgünstigen Herstellung , in der hohen Zuverlässigkeit der jeweiligen elektrisch leitenden Verbindung und darin, dass z. B. die Montage von chipförmigen Leistungshalbleiterbauelementen und die jeweilige Durchkontaktierung in einem gemeinsamen Verfahren möglich sind. Zur Optimierung der stoffschlüssigen Verbindung, vorzugsweise der Drucksinterverbindung hat es sich als zweckmäßig erwiesen, wenn die schaltstrukturierte Logikmetallschicht im Bereich der Ausnehmung auf der dem Substrat zugewandten Seite bspw. mit einer Silberschicht versehen ist. Demselben Zwecke kann es dienlich sein, wenn die schaltstrukturierte Metalllage der elektrischen Komponente, wie bspw. eines Substrates oder eines Leistungshalbleiterbauelementes, oberflächlich z.B. mit einer Silberlegierungsschicht versehen ist. Bei dieser Silberlegierungsschicht kann es sich um eine Silber/Gold-Legierungsschicht handeln.

Die schaltstrukturierte Logikmetallschicht der Verbundfolie ist vorzugsweise eine Kupferschicht, die schaltstrukturierte Leistungsmetallschicht der Verbundfolie ist zweckmäßigerweise eine Aluminiumschicht und die elektrisch isolierende Folie ist vorzugsweise eine Polyimidschicht. Selbstverständlich sind auch andere Metallkombinationen und Folienwerkstoffe anwendbar.

Handelt es sich bei der elektrischen Komponente um ein Substrat, dann ist die schaltstrukturierte Metalllage des Substrates vorzugsweise eine Kupferlage. Auf der von der schaltstrukturierten Metalllage abgewandten Seite des Substrates ist vorzugsweise eine vollflächige Metalllage vorgesehen, die vorzugsweise aus Kupfer besteht. Diese vollflächige Metalllage kann dazu dienen, die Schaltungsanordnung an einem Kühlbauteil flächig anzuordnen, um die in der Schaltungsanordnung generierte Verlustwärme in das Kühlbauteil abzuführen.

Weitere Einzelheiten, Merkmale und Vorteil ergeben sich aus der nachfolgenden Beschreibung eines in der Zeichnung schematisch und nicht maßstabgetreu gezeichneten Abschnittes einer Ausbildung der erfindungsgemäßen Schaltungsanordnung, wobei es sich versteht, dass die Erfindung nicht auf das gezeichnete Ausführungsbeispiel beschränkt sondern durch die Ansprüche definiert ist.

Es zeigen:
- Figur 1: eine Schnittansicht einer Ausbildung der Schaltungsanordnung, wobei die Verbundfolie vom Substrat beabstandet gezeichnet ist, und
- Figur 2: die Schaltungsanordnung gemäß Figur 1 im druckgesinterten Endzustand.

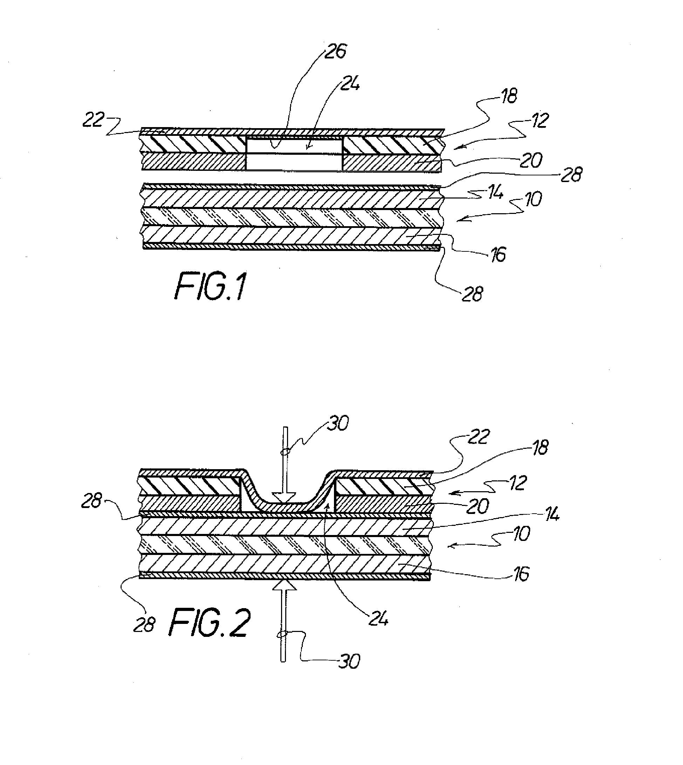

Figur 1 zeigt eine Ausbildung der Schaltungsanordnung mit einem Substrat 10 und mit einer davon beabstandet gezeichneten Verbundfolie 12. Das Substrat 10 weist an seiner der Verbundfolie 12 zugewandten Seite eine schaltstrukturierte Metalllage 14 und an der davon abgewandten anderen Seite eine vollflächige Metalllage 16 auf.

Die Verbundfolie 12 weist eine elektrisch isolierende Folie 18 auf. An der dem Substrat 10 zugewandten Seite weist die elektrisch isolierte Folie 18 eine schaltstrukturierte Leistungsmetallschicht 20 und an der davon abgewandten Seite eine schaltstrukturierte Logikmetallschicht 22 auf. Die schaltstrukturierte Leistungsmetallschicht 20 und die elektrisch isolierende Folie 18 der Verbundfolie 12 sind jeweils mit einer Ausnehmung 24 ausgebildet. Die Ausnehmung 24 in der elektrisch isolierenden Folie 18 und in der Metallschicht 20 können gleich groß oder verschieden groß sein. Ihre Ränder können konform oder voneinander verschieden sein. Die schaltstrukturierte Logikmetallschicht 22 ist im Bereich der Ausnehmung 24 auf der dem Substrat 10 zugewandten Seite mit einer Silberschicht 26 versehen. Die schaltstrukturierte Metalllage 14 des Substrates 10 ist oberflächlich mit einer Silberlegierungsschicht 28 versehen. Desgleichen ist die vollflächige Metalllage 16 des Substrates 10 mit einer Silberlegierungsschicht 28 versehen.

Zur Durchkontaktierung wird die Logikmetallschicht 22 durch die Ausnehmung 24 hindurch eingedrückt, bis sie an der schaltstrukturierten Metalllage 14 des Substrates 10 bzw. an der dort vorgesehenen Silberlegierungsschicht 28 anliegt. Gleichzeitig erfolgt bspw. ein Drucksintern, um die schaltstrukturierte Logikmetallschicht 22 mit der schaltstrukturierten Metalllage 14 des Substrates 10 elektrisch leitend zu verbinden. Die elektrisch leitende Verbindung, bspw. mittels eines Drucksintervorgangs ist in Figur 2 durch die einander zugewandten Pfeile 30 angedeutet.

Gleiche Einzelheiten sind in den Figuren 1 und 2 mit denselben Bezugsziffern bezeichnet, so dass es sich erübrigt, in Verbindung mit Figur 2 alle Einzelheiten noch einmal detailliert zu beschreiben.

Wie bereits erwähnt worden ist, kann der Drucksintervorgang durch eine beliebige andere stoffschlüssige Verbindung realisiert sein. Anstelle einer stoffschlüssigen Verbindung kann auch eine kraftschlüssige Verbindung hergestellt werden.

In den Figuren 1 und 2 ist eine Verbundfolie 12 gezeichnet, die mit einer Ausnehmung 24 ausgebildet ist, in welche die Logikmetallschicht 22 der Verbundfolie 12 eingedrückt wird. Selbstverständlich ist es auch möglich, eine Verbundfolie 12 anzuwenden, wobei die Logikmetallschicht 22 über den Rand der Isolierfolie 18 und den Rand der Leistungsmetallschicht 20 seitlich übersteht, so dass der Überstand der Logikmetallschicht 22 mit einer elektrischen Komponente 10, wie der Metallschicht eines Substrates oder eines Leistungshalbleiterbauelementes oder dergleichen stoffschlüssig, vorzugsweise durch Drucksintern, oder kraftschlüssig elektrisch leitend verbunden wird.

### Bezugsziffernliste:

- 10: elektrische Komponente
- 12: Verbundfolie
- 14: schaltstrukturierte Metalllage (an 10)
- 16: vollflächige Metalllage (an 10)
- 18: elektrisch isolierende Folie (von 12)
- 20: schaltstrukturierte Leistungsmetallschicht (an 18)
- 22: schaltstrukturierte Logikmetallschicht (an 18)
- 24: Ausnehmung (in 20 und 18)
- 26: Silberschicht (an 22 bei 24)
- 28: Silberlegierungsschicht (an 14)
- 30: Pfeile/elektrisch leitende Verbindung (von 22 an 14)

## Patentansprüche

1. Schaltungsanordnung mit einer elektrischen Komponente (10), das eine schaltstrukturierte Metalllage (14) aufweist, und mit einer Verbundfolie (12), die eine schaltstrukturierte Logikmetallschicht (22) und eine schaltstrukturierte Leistungsmetallschicht (20) und zwischen diesen Schichten (20 und 22) eine elektrisch isolierende Folie (18) aufweist, **dadurch gekennzeichnet,**
**dass** die schaltstrukturierte Leistungsmetallschicht (20) und die elektrisch isolierende Folie (18) mit einer Ausnehmung (24) ausgebildet sind, dass die Logikmetallschicht (22) durch die Ausnehmung (24) hindurch, an der schaltstrukturierten Metalllage (14) der elektrischen Komponente (10) anliegend, eingedrückt ist, und dass die Logikmetallschicht (22) mit der schaltstrukturierten Metalllage (14) der elektrischen Komponente (10) elektrisch leitend verbunden ist.

2. Schaltungsanordnung nach Anspruch 1,
**dadurch gekennzeichnet,**
**dass** die schaltstrukturierte Logikmetallschicht (22) im Bereich der Ausnehmung (24) an der dem Substrat (10) zugewandten Seite mit einer Silberschicht (26) versehen ist.

3. Schaltungsanordnung nach Anspruch 1,
**dadurch gekennzeichnet,**
**dass** die schaltstrukturierte Metalllage (14) des Substrates (10) oberflächlich mit einer Silberlegierungsschicht (28) versehen ist.

4. Schaltungsanordnung nach Anspruch 1,
**dadurch gekennzeichnet,**
**dass** die schaltstrukturierte Logikmetallschicht (22) eine Kupferschicht ist, dass die schaltstrukturierte Leistungsmetallschicht (20) eine Aluminiumschicht ist, und dass die Kunststofffolie (18) eine Polyimidfolie ist.

5. Schaltungsanordnung nach Anspruch 1,
**dadurch gekennzeichnet,**
**dass** die schaltstrukturierte Metalllage (14) der elektrischen Komponente (10) eine Kupferlage ist.

6. Schaltungsanordnung nach Anspruch 1,
**dadurch gekennzeichnet,**
**dass** auf der von der schaltstrukturierten Metalllage (14) abgewandten Seite der elektrischen Komponente (10) eine vollflächige Metalllage (16) vorgesehen ist.

7. Schaltungsanordnung nach Anspruch 6,
**dadurch gekennzeichnet,**
**dass** die vollflächige Metalllage (16) eine Kupferlage ist.
